Europäisches Patentamt

European Patent Office

Office européen des brevets

(19)

(11) Publication number: **0 235 503 B1**

# EUROPEAN PATENT SPECIFICATION

(12)

(45) Date of publication of patent specification: **01.04.92**

(51) Int. Cl.5: **H01L 25/16**, H01L 23/053, H01L 23/66

(21) Application number: **87100266.3**

(22) Date of filing: **12.01.87**

(54) hermetic high frequency surface mount microelectronic package.

(30) Priority: **24.02.86 US 832921**

(43) Date of publication of application:
**09.09.87 Bulletin 87/37**

(45) Publication of the grant of the patent:
**01.04.92 Bulletin 92/14**

(84) Designated Contracting States:
**BE DE FR GB SE**

(56) References cited:
GB-A- 2 007 911
GB-A- 2 065 970

PATENT ABSTRACTS OF JAPAN, vol. 6, no. 132 (E-119)[1010], 17th July 1982; & JP-A-57 56 953

PATENT ABSTRACTS OF JAPAN, vol. 5, no. 44 (E-50)[716], 24th March 1981; & JP-A-55 166 941

(73) Proprietor: **Hewlett-Packard Company
Mail Stop 20 B-O, 3000 Hanover Street
Palo Alto, California 94304(US)**

(72) Inventor: **Ellenberger, John C.
749 Rogers Court
Santa Clara, CA 95051(US)**
Inventor: **Yoo, Inbae
2946 Forbes Avenue
Santa Clara, CA 95051(US)**
Inventor: **Burdick, Eugene V.
708 Coney Court
Santa Rosa,CA 95405(US)**

(74) Representative: **Liesegang, Roland, Dr.-Ing.
FORRESTER & BOEHMERT Franz-
Joseph-Strasse 38
W-8000 München 40(DE)**

## Description

The invention relates generally to hermetically sealed packages for high frequency microelectronic circuits, and in particular to a high reliability package for microwave hybrid and integrated circuits.

The operating frequency for data processing and data communications circuits is rapidly increasing, from the KHz range to the GHz range. At high frequency, the parasitic capacitance and inductance of the package enclosing the hybric circuit or IC becomes a major factor, and as a result, the package must be considered a part of the circuit. Also, component densities and heat dissipation requirements are increasing, thus requiring the package to be a good thermal conductor. In these high frequency applications, the package must be compatible with microstrip transmission lines, and surface mount packages are becoming the industry standard. In addition, for analog circuits operating above about 500 MHz, it is very important that the package provide a good RF ground.

Existing packages for microelectronic circuits provide for some but not all of these needs. Traditional chip carriers and ceramic and metal flat packs cannot operate at high frequency, do not provide good RF grounding, and can handle only low power applications. Metal packages, e.g., TO-8 or TO-l2 types, are not readily adaptable for housing ICs, cannot be surface mounted, and have a high VSWR at microwave frequencies.

One prior package known to the inventor comes close to meeting all of the criteria required, but due to its parasitic inductance and capacitance, its performance deteriorates at frequencies above 5 GHz. The construction of the package also makes it relatively expensive. A cross sectional view of the construction of this package is shown in Figure l. The package comprises a base ll, a lid l3, leads l5 and a ground plane attachment pad l7. The top surface of the base ll carries thin or thick film circuit elements l9 and components 2l. The circuit elements and components are connected to the leads l5 by plated through holes 23 in the base. Other plated through holes, not shown, connect to the ground plane attachment pad l7 to provide an RF ground. The lid is brazed to the top surface of base ll to make a hermetic seal 25 around the perimeter. The plated through holes, however, still must be sealed to hermetically seal the package. To do this, the leads and ground plane attachment pad must be carefully brazed to the bottom of the base. This requires precise process control and adds to the cost of assembly of the package. In addition, there is no good RF ground plane along the plated through holes so the VSWR of the package becomes high above about 3 GHz. Also, due to the general design of leads l5 and ground plane attachment pad l7, both need to be soldered to the PC board. Because leads l5 are mounted onto the bottom of base ll, the user cannot inspect the package for solder bridging between pad l7 and leads l5 after attachment to the PC board.

An object of the invention is to provide a hermetic package for microelectronic circuits such as microwave frequency ICs and hybrid circuits, which can be surface mounted, has low parasitic capacitance and low inductance to RF ground, lead impedence close to 50 ohms and good power dissipation.

Another object of the invention is to provide a hermetic package for microelectronic circuits that has low piece part and assembly costs and is adapted to automated assembly.

These and other advantages are provided according to the invention by a package as set out in claim 1.

The vias are cofired with the ceramic base and provide good power dissipation because of their thermal conductivity. The vias can be located at any position on the area of the base giving flexibility to the circuit designer by providing good RF grounds for the circuit and can be used to isolate different stages in the circuit and heat sink higher power dissipated components. Because the vias are hermetically sealed, the package is more cost effective. No separate bottom component and no brazing operation is required to hermetically seal the package. Thus, the construction essentially eliminates the "classical" package reducing piece part and assembly costs and eliminating the electrical transition from the package to the circuit.

The leads have a tapered section so the leads are wider outside the package reducing inductance and narrower going through the ceramic frame to reduce capacitance, thus tuning the leads to close to 50 ohm impedance. A layer of conducting silver loaded solder glass underneath the lead electrically connects the lead to the circuit and seals the lead to the base. A nonconducting layer of lead oxide solder glass over the lead hermetically seals the lead between the ceramic frame and the ceramic base. The top surface of the frame has a metallized layer so that the lid can be hermetically sealed to the frame by soldering.

Because the leads extend out of the side of the package, the user can inspect for solder bridging between the package base and the leads after the package has been soldered to the PC board.

This construction overcomes the problems of prior packages to provide a hermetic package which can be surface mounted, has low parasitic inductance to RF ground, 50 ohm lead impedance and good power dissipation.

Brief Description of the Drawings

Figure I shows a cross-sectional view of a hermetically sealed microwave IC and hybrid package known in the prior art.

Figure 2 shows a cross-sectional view of a hermetically sealed microwave IC and hybrid package constructed in accordance with the invention.

Figure 3 is a more detailed illustration of one of the leads of the package shown in Figure 2.

Figure 4 is an exploded view of the components of the package shown in Figure 2.

Figure 5 is a flow chart showing the process steps used for assembly of a package in accordance with the invention.

Detailed Description of the Invention

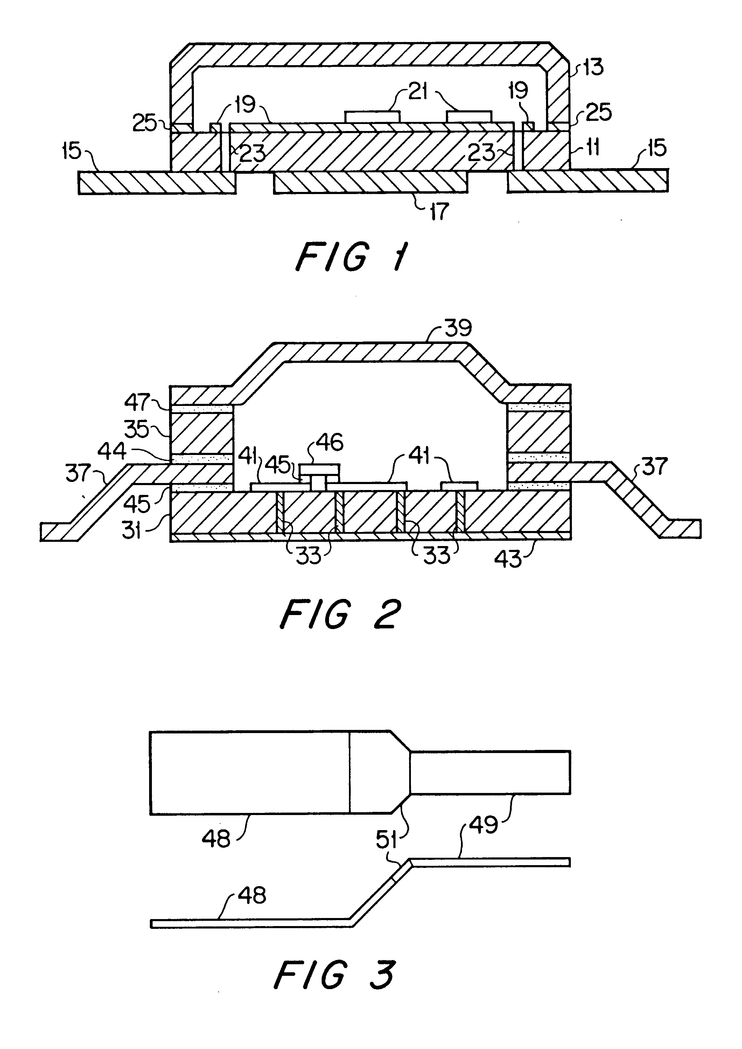

The package for microelectronic circuits, shown in Figure 2, comprises a ceramic base 3I on which the microwave circuit elements and components are mounted, a ceramic frame 35 sealed to the top of the base, conductive leads 37 sealed between the frame and the base for connecting input and output signals to the circuits contained in the package, and a lid 39 sealed to the top of ceramic frame 35. Base 3I has conductive vias 33 which are cofired with the base so that they provide a hermetic seal. The vias provide both RF ground connections and good power dissipation paths for the components and circuit devices.

Ceramic base 3I which forms both the bottom of the package and the substrate for the microcircuitry is made of 96% or 99.5% alumina depending on whether the microcircuitry is thick film or thin film circuitry. The vias 33 are formed in the pre-fired alumina and filled with a tungsten paste. The alumina substrate and tungsten paste are then cofired so that there is a hermetic seal between the insulating alumina and the conducting tungsten filled material. After firing, thin film or thick film circuit elements are coated onto the top of the alumina base. Thin film systems require the 99.5% alumina and are used typically when high circuit densities are required. Thus, the top of the base carries circuit conductor and resistor patterns 4I. The bottom of the base is completely metallized, for example, with a tungsten layer or a thin film metal system to provide a ground plane 43 which makes electrical contact with the RF ground plane of the PC board on which the package is mounted.

The conductive vias can be located at any part of the circuit in which the designer requires a good connection to RF ground and thus provide low inductance grounding for the circuit, a convenient means for isolating different stages of the circuit and heat sinking for high power dissipation components. Also, because the vias provide hermetic seals, ceramic base 3I can be used both as the substrate to carry the microcircuit elements and as the hermetic base of the package without the need for an additional metal sealing component which must be brazed to the base. The combination of the ground plane 43 on the bottom of the base and the conducting vias 33 results in a very low package inductance to ground, allowing the package to be used in high frequency analog and digital applications. Moreover, because the package can be used with thin film metallization circuitry, the frequency range for analog circuits is further extended.

The leads 37 are made of Kovar (ASTM alloy I5) which has the same thermal expansion coefficient as the alumina base 3I and frame 35. To meet the requirements of high reliability standards, the leads are first nickel plated and then gold plated. The gold plating is done selectively, leaving the portion 49 of leads 37 which is inserted into the package between base 3I and frame 35 unplated. This is necessary to achieve a hermetic seal with the lead oxide solder glass around the leads as described later. The leads can be supplied in lead frame form to aid in manufacturability and to make the process of assembly of the package suitable for automation. The leads are formed to the proper shape in the lead frames to provide for surface mount configuration of the package. In this form, they also conveniently provide for alignment of the leads to the substrate by nesting the substrate in the pocket formed by the leads.

The leads are tapered just at the point where they enter the package in order to provide for a low VSWR at microwave operating frequencies. The taper allows a wider lead outside the package, reducing inductance, and a narrower lead going through the side wall between base 3I and frame 35 to reduce capacitance. Figure 3 shows details of the shape of a typical lead. The lead 37 has a wide portion 48 and a thin portion 49 which are connected by a tapering section 5I. The wide portion 48 is formed to provide a convenient connection from the base to the mounting circuit board for surface mounting. Taper 5I is located just where the lead enters the package. Thin section 49 provides a low capacitance connection through the wall of the package to the circuit elements inside. In one particular example which has been found to work well, the portion 48 is .020 inches wide, portion 49 is .0II inches wide and the angle of taper 5I is 45 degrees. Using this lead geometry provided a package with a VSWR of I.2:I through 5 GHz.

Leads 37 are attached to the contact pads on base 3I with a silver loaded solder glass layer 45 (e.g. JMI 4600 series or equivalent) which assures electrical conductivity as well as a hermetic seal between the leads and the base.

Ceramic frame 35 provides a side wall for the package around the perimeter of base 3l. The top surface of frame 35 has a tungsten or molybdenum-manganese layer plated with nickel then gold so that the lid 39 can be soldered on creating a hermetic seal. The bottom of frame 35 is coated with a layer of nonconducting lead oxide solder glass 44 (e.g. Tl9IBF type or equivalent). The lead oxide solder glass forms a non-conducting hermetic seal with the alumina surfaces of frame 35 and base 3l and with the nickel-plated surfaces of leads 37. This seal also provides structural strength for attaching the leads to the package. The top surface of frame 35 also has bond points in each corner so that the metal lid can be grounded, to reduce electromagnetic emissions and shield against interference.

The lid 39 is made of Kovar (ASTM alloy l5) and plated with nickel and gold to meet the requirements of high reliability standards. Here again, Kovar is used because it has the same thermal expansion as the ceramic material of the base and frame. The lids are stamped to form a dome of an appropriate size to house the microcircuit elements.

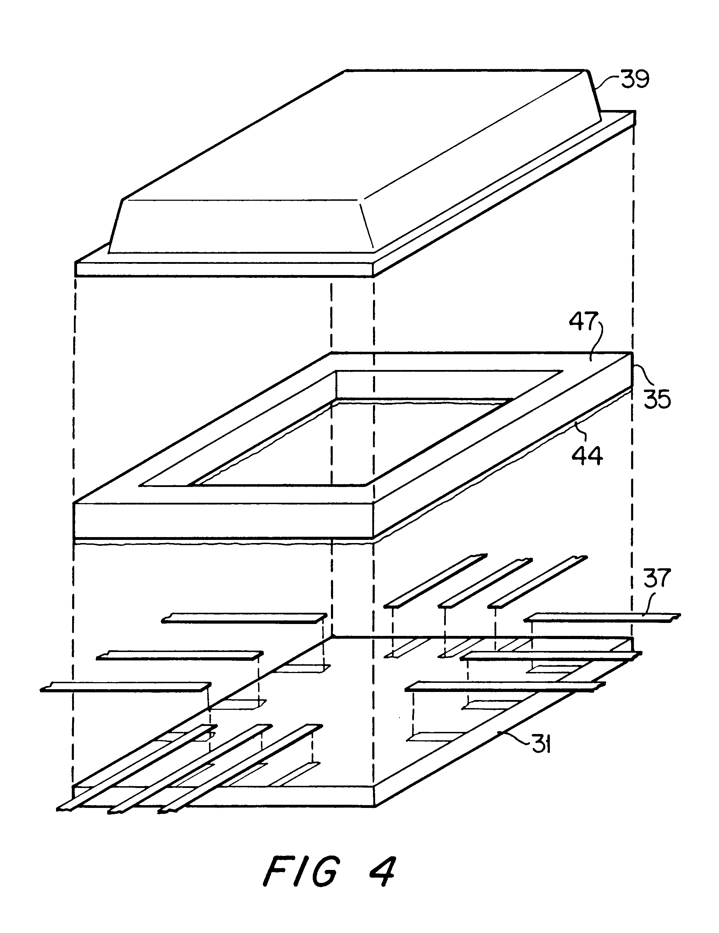

The overall construction of the package and the connection of the leads between base 3l and frame 35 can more easily be seen by reference to Figure 4 which shows an exploded view of the components of the package. Figure 4 shows how a number of leads 37 (taper and forming not shown) can be attached to the input/output pads of the circuitry on base 3l. That lead oxide solder glass layer 44 is applied to the bottom surface of frame 35 before frame 35 is affixed to the top of the base over the leads 37. Figure 4 also shows how the solderable top surface 47 of frame 35 mates with lid 39 to provide a surface for soldering the lid 39 to the package to form a hermetic seal.

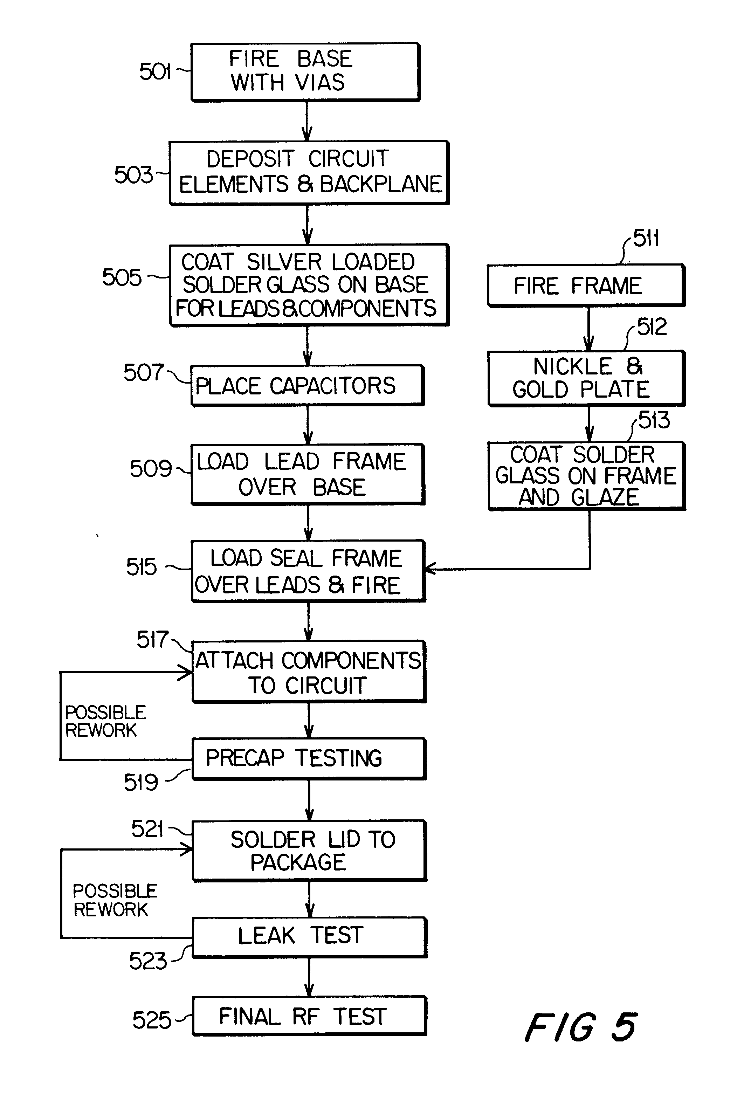

The process for assembling the package proceeds according the flow chart shown in Figure 5. First, in step 50l, the ceramic base is fired with the conductive tungsten paste vias in place. Next, in step 503, the conductive and resistive circuit elements 4l are deposited on the top surface of the base and the metallized groundplane 43 is deposited on the bottom surface of the base. Then, in step 505, a selective coating of silver loaded solder glass 45 is coated onto the metallization areas before attachment of the leads 37 and also certain microcircuit components. Only components which can withstand the 420 C temperatures for firing the solder glass seals can be placed on the circuit at this time. This includes, for example, microwave capacitors, such as capacitor 46 shown in Figure 2, which are placed on the base in step 507. In step 509, the leads in the form of a lead frame discussed earlier, are placed over the base in alignment with the contact pads on the circuit traces. At this point, the base assembly is ready to be mated with frame 35. The frame 35 is prepared for assembly in steps 5ll and 5l3. First, frame 35 is fired with a top tungsten or molybdenum-manganese layer 47, in step 5ll. Then the tungsten or molybdenum-manganese is nickel and gold plated, step 5l2 and finally, the layer of lead oxide solder glass is silk screened onto the bottom surface of the frame and glazed, in step 5l3. At this point, the frame is ready to be mated with the base over the leads and the entire base and frame assembly is heated to cure the solder glass, step 5l5. The curing is done by heating the assembly to 420 degrees C in air for five minutes. This forms a hermetic seal as well as a structural bond for attaching the leads to the package. The lead oxide solder glass is chosen for its combination of strength, low curing temperature and low dielectric constant. The silver loaded solder glass has characteristics very similar to the lead oxide solder glass except it is conductive. So the curing of the solder glass layers can be done in one operation. The relatively low curing temperature does not harm the capacitors placed on the circuit nor does it harm the thin film resistor circuit elements.

At this point, the remaining heat sensitive circuit components can be attached to the circuit traces. This can be done by a variety of suitable methods, including wire bonding. After the components are attached, step 5l7, testing of the circuit can be done before the lid is attached and sealed. This testing is done in step 5l9. If necessary, the attachment of components can be reworked if testing finds faulty components or faulty connections. After testing is complete, in step 52l, the lid is soldered to the top of the package to provide a total hermetic seal. The soldering is done with gold tin alloy solder in an inert or reducing atmosphere. The low temperature of this process protects the components that cannot withstand the 420 C curing temperature and provides the interior of the case with a dry innert atmosphere. After soldering, the package is leak tested, in step 523, and reworked if necessary to insure proper hermetic sealing. Finally, in step 525, final RF testing of the circuit is performed.

## Claims

1. A hermetically sealed microelectronic circuit package comprising: a ceramic base (31) having a top surface with microelectronic circuit elements (46) formed thereon; a plurality of conductive leads (37) attached to said circuit elements (46) on the top surface of the ceramic base (31), said conductive leads (37) extending from the sides of the package to provide external electrical connections to the microelectronic circuit in the package; a ceramic frame (35) forming the side walls of the package; and a lid (39) sealed to the top surface of the ceramic frame (35);

wherein :

said ceramic base (31) has hermetically sealed conductive vias (33) extending through the ceramic base (31) from the top surface to the bottom surface thereof;

said plurality of conductive leads (37) are attached to the top surface of the ceramic base (31) with a conductive heat flowable material (45) that forms a hermetic seal;

said ceramic frame (35) is sealed to the top surface of the ceramic base (31) and to the conductive leads (37) with a nonconducting heat flowable material (44) that forms a hermetic seal whereby the conductive leads (37) are hermetically sealed between the ceramic frame (35) and the ceramic base (31);

said ceramic frame (35) has a top surface with a metallized layer (47);

said lid (39) has a solderable bottom surface hermetically sealed to the metallized top surface of the ceramic frame (35); and the bottom surface of the ceramic base (31) is metallized to provide a ground plane.

**2.** The package of claim 1 wherein the conductive heat flowable material (45) is a silver loaded solder glass, and the nonconducting heat flowable material (44) is a lead oxide solder glass.

**3.** The package of either of claims 1 or 2, wherein the conductive leads (37) are tapered at the point where they emerge from the package side, with a narrow portion (49) extending between the ceramic base (31) and the ceramic frame (35), and a wide portion (48) formed to make a surface mounting connection with a printed circuit board.

**Revendications**

**1.** Un boîtier hermétiquement fermé pour circuit de micro-électronique comprenant : une base (31) en céramique comportant une surface supérieure sur laquelle sont formés des éléments (46) de circuit de micro-électronique; une pluralité de conducteurs (37) attachés auxdits éléments (46) de circuit sur la surface supérieure de la base (31) en céramique, lesdits conducteurs (37) s'étendant depuis les côtés de boîtier pour constituer des liaisons électriques extérieures du circuit de micro-électronique situé dans le boîtier; un cadre (35) en céramique formant les parois latérales du boîtier; et un couvercle (39) attaché de façon étanche à la surface supérieure du cadre (35) en céramique; dans lequel :

ladite base (31) en céramique comprend des traversées conductrices fermées hermétiquement traversant la base (31) en céramique depuis sa surface supérieure jusqu'à sa surface inférieure;

ladite pluralité de conducteurs (37) sont attachés à la surface supérieure de la base (31) en céramique à l'aide d'une matière conductrice (45) pouvant fluer à la chaleur, qui forme un joint hermétique;

ledit cadre (35) en céramique est attaché de façon hermétique sur la surface supérieure de la base (31) en céramique et sur les conducteurs (37) à l'aide d'une matière (44) non conductrice, pouvant fluer à la chaleur, qui forme une fermeture hermétique grâce à quoi les conducteurs (37) sont enfermés de façon hermétique entre le cadre (35) en céramique et la base (31) en céramique;

ledit cadre (35) en céramique conporte une surface supérieure portant une couche métallisée (47);

ledit couvercle (39) comporte une surface inférieure pouvant être brasée, attachée de façon hermétique à la surface supérieure métallisée du cadre (35) en céramique; et la surface inférieure de la base (31) en céramique est métallisée pour constituer un plan formant masse.

**2.** Le boîtier selon la revendication 1 dans lequel la matière conductrice (45) pouvant fluer à chaud est un verre de brasure chargé à l'argent, et la matière non conductrice (44) pouvant fluer à la chaleur est un verre de brasure à l'oxyde de plomb.

**3.** Le boîtier selon l'une des revendications 1 et 2, dans lequel les conducteurs (37) sont effilés au point où ils émergent du côté du boîtier, une partie étroite (49) s'étendant entre la base (31) en céramique et le cadre (35) en céramique et une partie large (48) étant formée pour constituer une liaison de montage en surface avec une carte de circuit imprimé.

**Patentansprüche**

**1.** Luftdicht verschlossenes Keramikgehäuse für einen mikroelektronischen Schaltkreis, mit einem Keramiksockel (31), der eine obere Oberfläche mit darauf ausgebildeten mikroelektronischen Schaltungselementen (46) aufweist, mehreren an den Schaltungselementen auf der Oberfläche des Keramiksockels (31) angebrachten leitfähigen Anschlüssen (37), die von den Seiten des Bausteins abstehen, um externe elektrische Verbindungen zum mikroelektronischen Schaltkreis in dem Gehäuse zu bilden, einem die Seitenwände des Gehäuses bildenden Keramikrahmen (35) und einem mit der oberen Oberfläche des Keramikrahmens (35) abdichtenden Deckel (39), bei dem

der Keramiksockel (31) luftdicht verschlossene, leitfähige Pfade (33) aufweist, die sich durch den Keramiksockel (31) von dessen oberer Oberfläche zur unteren Oberfläche erstrecken, die mehreren leitfähigen Anschlüsse (37) auf der oberen Oberfläche des Keramiksockels (31) mit einem leitfähigen, bei Wärme fließfähigen Werkstoff (45), der einen luftdichten Verschluß bildet, befestigt sind,

der Keramikrahmen (35) mit der oberen Oberfläche des Keramiksockels (31) und den leitfähigen Anschlüssen (37) mit einem nicht leitfähigen, bei Wärme fließfähigen Werkstoff (44) abdichtet, wobei dieser Werkstoff einen luftdichten Verschluß bildet und die leitfähigen Anschlüsse (37) luftdicht zwischen dem Keramikrahmen (35) und dem Keramiksockel (31) eingeschlossen sind,

der Keramikrahmen (35) eine obere Oberfläche mit einer Metallschicht (37) aufweist,

der Deckel (39) eine lötbare untere Oberfläche aufweist, die luftdicht mit der metallisierten oberen Oberfläche des Keramikrahmens (35) abdichtet, und bei dem die untere Oberfläche des Keramiksockels (31) metallisiert ist, um eine Masse-Ebene vorzusehen.

2. Gehäuse nach Anspruch 1, bei dem der leitfähige, bei Wärme fließfähige Werkstoff (45) ein Lötglas mit Silberzusatz und der nicht leitfähige, bei Wärme fließfähige Werkstoff (44) ein Bleioxid-Löglas ist.

3. Gehäuse nach Anspruch 1 oder 2, bei dem die leitfähigen Anschlüsse (37) an den Stellen, an denen sie von den Gehäuseseiten austreten, verjüngt sind, mit einem sich zwischen dem Keramiksockel (31) und dem Keramikrahmen (35) erstreckenden verengten Abschnitt (49) und einem breiten Abschnitt (48), der zum Herstellen einer Oberflächenmontage-Verbindung mit einer gedruckten Leiterplatte ausgebildet ist.

FIG 1

FIG 2

FIG 3

FIG 4

501 — FIRE BASE WITH VIAS

503 — DEPOSIT CIRCUIT ELEMENTS & BACKPLANE

505 — COAT SILVER LOADED SOLDER GLASS ON BASE FOR LEADS & COMPONENTS

507 — PLACE CAPACITORS

509 — LOAD LEAD FRAME OVER BASE

511 — FIRE FRAME

512 — NICKLE & GOLD PLATE

513 — COAT SOLDER GLASS ON FRAME AND GLAZE

515 — LOAD SEAL FRAME OVER LEADS & FIRE

517 — ATTACH COMPONENTS TO CIRCUIT

POSSIBLE REWORK

519 — PRECAP TESTING

521 — SOLDER LID TO PACKAGE

POSSIBLE REWORK

523 — LEAK TEST

525 — FINAL RF TEST

*FIG 5*